# EUROPEAN PATENT APPLICATION

(11) **EP 4 692 819 A1**
(43) Date of publication of application: **11.02.2026**
(21) Application number: 25192657.2
(22) Date of filing: 29.07.2025
(51) Int. Cl.: G01R 31/367, G01R 31/392

(54) **APPARATUS AND METHOD FOR CHECKING SOH USING CHARGE AND DISCHARGE CHARACTERISTICS OF TEST BATTERY IN USE**

(30) Priority: 06.08.2024 KR 20240104303; 04.11.2024 KR 20240154283
(71) Applicant: Apro Co., Ltd, Anyang-si, Gyeonggi-do 14055 (KR)
(72) Inventor: LIM, Jong Hyun, 14055 Gyeonggi-do (KR); KIM, Chang Gyun, 14055 Gyeonggi-do (KR); KO, Won Seok, 14055 Gyeonggi-do (KR); SON, Yu Jin, 14055 Gyeonggi-do (KR)
(74) Representative: Sander, Rolf

(57) **Abstract**

An apparatus for checking a state of health (SOH) includes a discharge unit that discharges a test battery, a charge unit that charges the test battery by providing charge power, a data collection unit that selects points in the discharge or charge process and collects input data in the discharge or charge process or at the selected points, a sensor unit that senses a voltage of the test battery, a data generation unit that receives the input data and the voltage and generates charge voltage curve data or discharge voltage curve data of the test battery, a first prediction unit that predicts the discharge voltage curve data based on the charge voltage curve data by using a pre-trained first Al learning model, and a second prediction unit that checks the SOH of the test battery based on the discharge voltage curve data by using a pre-trained second AI learning model.

## Description

### CROSS-REFERENCE TO RELATED APPLICATIONS

This application claims priority to Korean Patent Application No. 10-2024-0104303, filed on August 6, 2024 and Korean Patent Application No. 10-2024-0154283, filed on November 4, 2024, the entire contents of which are herein incorporated by reference.

### BACKGROUND

### 1. Technical Field

The present embodiments relate to an apparatus and method for checking the state of health (SOH) using charge and discharge characteristics of a test battery in use.

### 2. Related Art

Contents described in this part merely provide background information of the present embodiment, and do not constitute a conventional technology.

A battery plays a role as an important energy source in various fields, such as electric vehicles, renewable energy systems, smart grids, and portable electronics. The battery has its capacity gradually reduced as the battery is continuously charged and discharged and is considered to be a failure when the capacity drops to 80% or less compared to its initial capacity. Accordingly, lifespan prediction techniques for predicting a reduction in the capacity of the battery are actively developed.

Factors relating to the state of the battery may be basically divided into the state of charge (SOC), the state of health (SOH), and the state of life (SOL). The SOC, that is, a charge state, among the factors, has been researched from a long time ago, but the SOH that evaluates the integrity and performance of the battery and the SOL that predicts a failure of the battery are recently actively researched.

The SOH of the battery is to evaluate the level of the capacity that has dropped so far, and includes the lifespan, storage capacity, and efficiency of the battery. However, in order to accurately measure the SOH of the battery, a full charge/discharge test needs to be performed. It is impossible to measure the SOH of the battery while the battery is being used. It is not effective to measure the SOH of the battery because it takes a long time to measure the SOH of the battery. However, it is very important to accurately check the SOH of the battery in electric vehicles, portable electronic devices, and energy storage systems. The fast and accurate evaluation of the SOH enables efficient management and optimized use of the battery, and can improve the reliability and stability of the entire system.

Accordingly, in a battery system, there is an increasing demand for a more accurate and efficient SOH evaluation method while solving a data storage space problem and a continuous battery reliability problem according to the enlargement of an application along with the development of the battery technology.

### SUMMARY

Embodiments of the present disclosure are directed to providing an apparatus and method for checking the SOH, which can test the SOH of a test battery in use by using a pre-trained AI learning model and check the SOH of the test battery rapidly and accurately.

According to an aspect of the present disclosure, an apparatus for checking the state of health (SOH) includes a discharge unit configured to perform discharge on a test battery that is a check target in a preset environment, a charge unit configured to perform charge on the test battery by providing charge power in a preset environment, a data collection unit configured to select a set number of points in a process of the test battery being discharged or charged by the discharge unit or the charge unit and to collect input data in the process of the test battery being charged or discharged or at the selected points, a sensor unit configured to sense a voltage of the test battery, a data generation unit configured to receive the input data collected by the data collection unit and the voltage of the test battery sensed by the sensor unit and to generate charge voltage curve data or discharge voltage curve data of the test battery, a first prediction unit configured to predict the discharge voltage curve data of the test battery based on the charge voltage curve data by using a first artificial intelligence (AI) learning model that has been pre-trained, and a second prediction unit configured to check an SOH of the test battery based on the discharge voltage curve data of the test battery by using a second AI learning model that has been pre-trained.

According to an aspect of the present disclosure, the apparatus further includes a pre-processing unit configured to perform pre-processing on the data collected by the data collection unit and a training unit configured to train the first AI learning model by training preset architecture by using data that have experienced the pre-processing unit as an input value and a battery-available maximum capacity as an output value.

According to an aspect of the present disclosure, the training unit trains the second AI learning model using the charge voltage curve data of the test battery as an input value and the discharge voltage curve data of the test battery as an output value.

According to an aspect of the present disclosure, the apparatus further includes a counter configured to count a charge time that is taken to fully charge the test battery and a discharge time that is taken to discharge the test battery and to transmit the counted charge time or discharge time to the data generation unit.

According to an aspect of the present disclosure, the preset number is approximately 20, within a predefined allowable error margin.

According to an aspect of the present disclosure, the data collection unit selects a preset number of points at time intervals.

According to an aspect of the present disclosure, a method of checking a state of health (SOH) of a test battery, which is performed by a computing apparatus including at least one processor and includes a charge process of charging a test battery by providing charge power in a preset environment, a discharge process of discharging the test battery in a preset environment, a collection process of selecting a set number of points in the process of the test battery being charged or discharged and collecting input data in the process of the test battery being charged or discharged or at the selected points, a data generation process of generating charge voltage curve data or discharge voltage curve data of the test battery based on input data collected in the collection process and a voltage sensed in the process of the test battery being charged or discharged, a first prediction process of predicting the discharge voltage curve data of the test battery based on the charge voltage curve data by using a first artificial intelligence (AI) learning model that has been pre-trained, and a second prediction process of checking an SOH of the test battery based on the discharge voltage curve data of the test battery by using a second AI learning model that has been pre-trained.

According to an aspect of the present disclosure, the method further includes a pre-processing process of pre-processing input data collected in the collection process and a training process of training the second AI learning model using data pre-processed in the pre-processing process as an input value and a battery-available maximum capacity as an output value.

According to an aspect of the present disclosure, the training process includes training the first AI learning model using the charge voltage curve data of the test battery as an input value and the discharge voltage curve data as an output value.

According to an aspect of the present disclosure, the collection process includes collecting a charge time that is taken to fully charge the test battery and a discharge time that is taken to discharge the test battery.

According to an aspect of the present disclosure, the preset number is approximately 20, within a predefined allowable error margin.

According to an aspect of the present disclosure, the collection process includes selecting a preset number of points at time intervals.

According to an aspect of the present disclosure, the collection process includes selecting a preset number of points at arbitrary times.

As described above, according to an aspect of the present embodiment, it is possible to check the SOH of a test battery rapidly and accurately by testing the SOH of the test battery in use by using the second AI learning model that has been pre-trained.

Furthermore, according to an aspect of the present embodiment, it is possible to obtain a more accurate result value by predicting discharge voltage curve data based on charge voltage curve data, that is, stable data, by using the first AI learning model and estimating the SOH through the second AI learning model by using the predicted discharge voltage curve data.

### BRIEF DESCRIPTION OF THE DRAWINGS

FIG. 1 is a block diagram of a computing apparatus according to an embodiment of the present disclosure.
FIG. 2 is a diagram illustrating a construction of an apparatus for checking the SOH according to an embodiment of the present disclosure.
FIG. 3 illustrates voltage change graphs according to times of a test battery that is charged and discharged by a charge unit and a discharge unit according to an embodiment of the present disclosure.
FIG. 4 illustrates various voltage change graphs according to times of test batteries that are discharged by the discharge unit according to an embodiment of the present disclosure.
FIG. 5 is a flowchart illustrating a method of training a second AI learning model that enables the apparatus for checking the SOH to check the SOH of a test battery according to an embodiment of the present disclosure.
FIG. 6 is a flowchart illustrating a method of pre-processing, by the apparatus for checking the SOH, data according to an embodiment of the present disclosure.
FIG. 7 is a flowchart illustrating a method of predicting, by the apparatus for checking the SOH according to an embodiment of the present disclosure, discharge voltage curve data based on the charge voltage curve data of a test battery through a first AI learning model.
FIG. 8 is a flowchart illustrating a method of testing, by the apparatus for checking the SOH according to an embodiment of the present disclosure, the SOH of a test battery by using an AI learning model.

### DETAILED DESCRIPTION

The present disclosure may be changed in various ways and may have various embodiments. Specific embodiments are to be illustrated in the drawings and specifically described. It should be understood that the present disclosure is not intended to be limited to the specific embodiments, but includes all of changes, equivalents and/or substitutions included in the spirit and technical range of the present disclosure. Similar reference numerals are used for similar components while each drawing is described.

Terms, such as a first, a second, A, and B, may be used to describe various components, but the components should not be restricted by the terms. The terms are used to only distinguish one component from another component. For example, a first component may be referred to as a second component without departing from the scope of rights of the present disclosure. Likewise, a second component may be referred to as a first component. The term "and/or" includes a combination of a plurality of related and described items or any one of a plurality of related and described items.

When it is described that one component is "connected" or "coupled" to the other component, it should be understood that one component may be directly connected or coupled to the other component, but a third component may exist between the two components. In contrast, when it is described that one component is "directly connected to" or "directly coupled to" the other component, it should be understood that a third component does not exist between the two components.

Terms used in this application are used to only describe specific embodiments and are not intended to restrict the present disclosure. An expression of the singular number includes an expression of the plural number unless clearly defined otherwise in the context. In this specification, a term, such as "include" or "have", is intended to designate the presence of a characteristic, a number, a step, an operation, a component, a part or a combination of them, and should be understood that it does not exclude the existence or possible addition of one or more other characteristics, numbers, steps, operations, components, parts, or combinations of them in advance.

The term "obtain" used in the present disclosure may be understood as meaning that data are generated in an on-device form in addition to receiving data over wired and wireless communication networks with an outside device or system.

The term "module" or "unit" used in the present disclosure may be understood as a term that denotes an independent function unit that processes computing resources like a computer-related entity, firmware, software or a part thereof, hardware or a part thereof, and a combination of software and hardware. In this case, the "module" or "unit" may be a unit including a single component, and may be a unit that is expressed as a combination or set of a plurality of components. For example, the "module" or "unit" as a narrow concept may be denoted as a hardware component of a computing apparatus or a set thereof, an application program that performs a specific function of software, a procedure that is implemented through software execution, or an instruction set for program execution. Furthermore, the "module" or "unit" as a wide concept may be denoted as a computing apparatus itself that constitutes a system or an application that is executed in a computing apparatus. In this case, the concept is merely an example, and the concept of the "module" or "unit" may be variously defined in a category which may be understood by those skilled in the art based on the contents of the present disclosure.

The tem "model" used in the present disclosure may be understood as a system that is implemented by using a mathematical concept and language in order to solve a specific problem, a set of software units for solving a specific problem, or an abstraction model relating to a procedure for solving a specific problem. For example, a neural network "model" may be denoted as an overall system that is implemented as a neural network having a problem-solving ability through learning. In this case, the neural network may have a problem-solving ability by optimizing a parameter that connects a node or a neuron through learning. The neural network "model" may include a single neural network, and may include a neural network set in which a plurality of neural networks has been combined.

All terms used herein, including technical terms or scientific terms, have the same meanings as those commonly understood by a person having ordinary knowledge in the art to which the present disclosure pertains, unless defined otherwise in the specification.

Terms, such as those defined in commonly used dictionaries, should be construed as having the same meanings as those in the context of a related technology, and are not construed as ideal or excessively formal meanings unless explicitly defined otherwise in the application.

Furthermore, each construction, process, procedure, or method included in each embodiment of the present disclosure may be shared within a range in which the constructions, processes, procedures, or methods do not contradict each other technically.

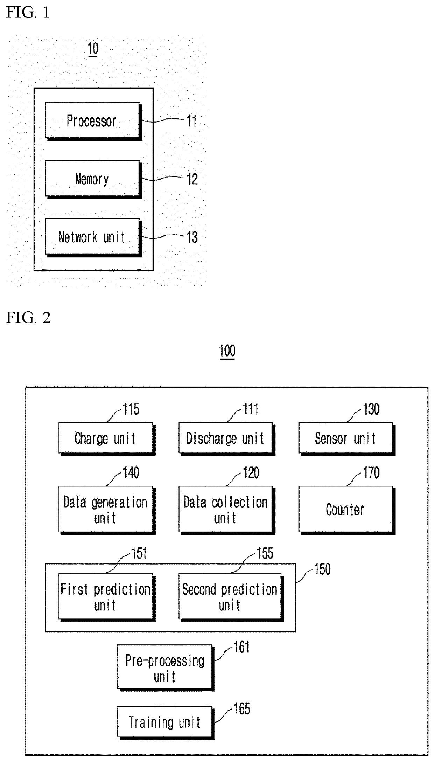

FIG. 1 is a block diagram of a computing apparatus according to an embodiment of the present disclosure.

A computing apparatus 10 according to an embodiment of the present disclosure is an apparatus for checking the SOH using charge and discharge characteristics of a test battery in use, may be a hardware apparatus that performs the comprehensive processing and operation of data or a part of the hardware apparatus, and may be a software-based computing environment that is connected thereto over a communication network. For example, the computing apparatus 10 may be a server, that is, the subject that performs an intensive data processing function and shares resources, and may be a client that shares resources through an interaction with a server. Furthermore, the computing apparatus 10 may be a cloud system in which a plurality of servers and clients comprehensively processes data through interactions. The above description is merely an example related to the type of computing apparatus 10. The type of computing apparatus 10 may be variously constructed in a category which may be understood by those skilled in the art based on the contents of the present disclosure.

Referring to FIG. 1, the computing apparatus 10 according to an embodiment of the present disclosure may include a processor 11, memory 12, and a network unit 13. In this case, FIG. 1 is merely an example. The computing apparatus 10 may include other components for implementing a computing environment. Furthermore, only some of the disclosed components may be included in the computing apparatus 10.

The processor 11 according to an embodiment of the present disclosure may be understood as a component unit that includes hardware and/or software for performing a computing operation. For example, the processor 11 may perform data processing for machine learning by reading a computer program. The processor 11 may process calculation processes, such as the processing of input data for machine learning, feature extraction for machine learning, and error calculation based on back-propagation. The processor 11 for performing such data processing may include a central processing unit (CPU), a general purpose graphics processing unit (GPGPU), a tensor processing unit (TPU), application specific integrated circuits (ASICs), or a field programmable gate array (FPGA). The type of processor 11 is merely an example. The type of processor 11 may be variously constructed in a category which may be understood by those skilled in the art based on the contents of the present disclosure.

The processor 11 may train a second artificial intelligence (AI) learning model that predicts the SOH or a first AI learning model that predicts discharge voltage curve data based on charge voltage curve data. The processor 11 may perform an operation of expressing at least one neural network block included in an AI learning model in a process of training the AI learning model. The processor 11 enables the AI learning model generated through the training process to predict discharge voltage curve data based on charge voltage curve data or to predict the SOH of a test battery based on discharge voltage curve data.

In addition to the example, the type of data for training the first and second AI learning models and the output of the AI learning model may be variously constructed in a category which may be understood by those skilled in the art based on the contents of the present disclosure. Furthermore, the first and second AI learning models may be integrated into a single network or may partially share some networks, and may be implemented as a separate independent network.

The memory 12 according to an embodiment of the present disclosure may be understood as a component unit that stores and manages data processed by the computing apparatus 10 and that includes hardware and/or software. That is, the memory 12 may store data having an arbitrary form, which is generated or determined by the processor 11, and data having an arbitrary form, which is received by the network unit 13. For example, the memory 12 may include at least one type of a storage medium, among a flash memory type, a hard disk type, a multimedia card micro type, card type memory, random access memory (RAM), static random access memory (SRAM), read-only memory (ROM), electrically erasable programmable read-only memory (EEPROM), programmable read-only memory (PROM), magnetic memory, a magnetic disk, and an optical disk. Furthermore, the memory 12 may also include a database system that manages data by controlling the data according to a predetermined system. The type of memory 12 is merely an example. The type of memory 12 may be variously constructed in a category which may be understood by those skilled in the art based on the contents of the present disclosure.

The memory 12 may manage data that are necessary for the processor 11 to perform an operation, a combination of data, and a program code that is executable by the processor 11 by structuring and organizing the data, the combination of data, and the program code. For example, the memory 12 may store the discharge voltage curve data of a battery that are received through the network unit 13 and various data for SOH estimation. The memory 12 may store a program code that enables the first and second AI learning models to perform learning, a program code that enables the first and second AI learning models to receive data and to perform inference based on a use purpose of the computing apparatus 10, and processing data that are generated as a program code is executed.

The network unit 13 according to an embodiment of the present disclosure may be understood as a component unit that transmits and receives data through a known wired and wireless communication systems having an arbitrary form. For example, the network unit 13 may perform data transmission and reception by using wired and wireless communication systems, such as a local area network (LAN), wideband code division multiple access (WCDMA), long term evolution (LTE), wireless broadband Internet (WIBRO), 5-generation (5G) mobile communication, an ultra wide-band, Zigbee, radio frequency (RF) communication, a wireless LAN, wireless fidelity, near field communication (NFC), or Bluetooth. The communication systems are each merely an example. The wired and wireless communication system for the data transmission and reception of the network unit 13 may be variously applied in addition to the examples.

The network unit 13 may receive data that are necessary for the processor 11 to perform an operation through wired and wireless communication with an arbitrary system or an arbitrary client. Furthermore, the network unit 13 may transmit data that are generated through an operation of the processor 11 through wired and wireless communication with an arbitrary system or an arbitrary client. The network unit 13 may transmit output data of an AI learning model and intermediate data or processing data that are derived in a calculation process of the processor 11, through communication with the database, the server, or the computing apparatus.

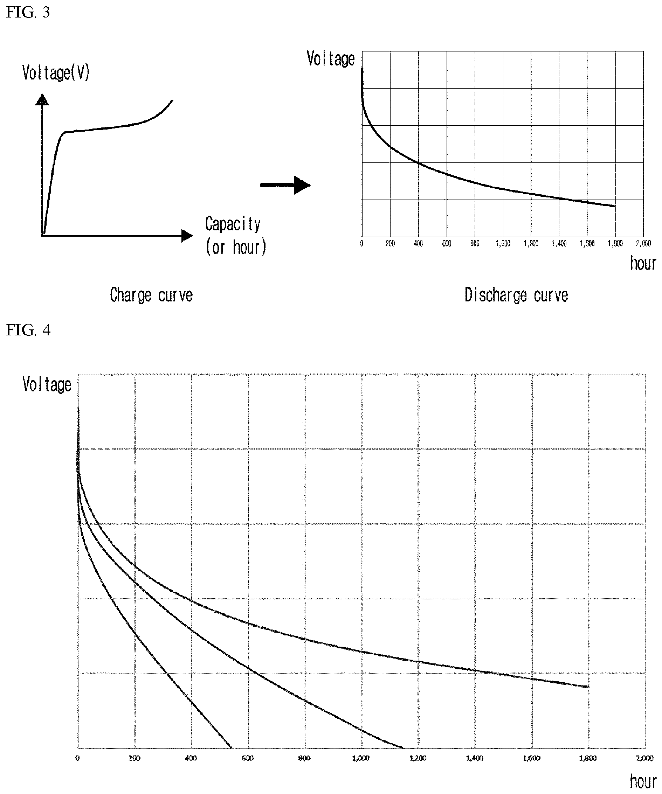

FIG. 2 is a diagram illustrating a construction of an apparatus for checking the SOH according to an embodiment of the present disclosure. FIG. 3 illustrates voltage change graphs according to times of a test battery that is charged and discharged by a charge unit and a discharge unit according to an embodiment of the present disclosure.

Referring to FIG. 2, an apparatus 100 for checking the SOH (hereinafter abbreviated as an "apparatus") according to an embodiment of the present disclosure includes a discharge unit 111, a charge unit 115, a data collection unit 120, a sensor unit 130, a data generation unit 140, a prediction unit 150, a pre-processing unit 161, a training unit 165, and a counter 170.

A battery denotes one battery cell or denotes that a plurality of battery cells has been electrically connected and modulated. In general, a battery that is used in electric vehicles, renewable energy systems, smart grids, and portable electronics includes a plurality of battery modules.

In this case, the SOH of a battery refers to current performance of the battery compared to the first performance of the battery, and is an index that indicates the current remaining lifespan and current performance level of the battery. The apparatus 100 may accurately measure the SOH of a test battery. In particular, the apparatus 100 may measure the SOH of a test battery in use relatively accurately while minimizing a test time for the test battery.

The discharge unit 111 performs discharge on a test battery, that is, a check target, in a preset environment. The charge unit 115 performs charge by providing a test battery with charge power in a preset environment.

The discharge unit 111 or the charge unit 115 can minimize a test time because the discharge unit 111 or the charge unit 115 directly performs discharge or charge on each test battery without separate pre-processing.

The charge unit 115 and the discharge unit 111 perform charge and discharge measurement in an environment suitable for charge and discharge that are set as items, such as a current, a voltage, and a temperature which may affect the capacity value of a battery, are set under a predetermined condition.

The data collection unit 120 selects a set number of points in a process of a test battery being discharged by the discharge unit 111 or a process of a test battery being charged by the charge unit 115, and collects input data in the charge or discharge process or at the selected points.

The data collection unit 120 may select a set number of points in a process of a test battery being discharged, and collect (some) input data at the selected points. The data collection unit 120 may select a preset number of points at time intervals and may select a preset number of points at arbitrary times. In this case, the preset number may be tens of points, and more specifically may be 20. The data collection unit 120 selects only a preset number of points in the entire process of a test battery being discharged. The data collection unit 120 may further select a point. However, the discharge of a test battery in a normal state is not performed within a total discharge process (time) of the test battery, but the discharge of a test battery that is not normal may be ended depending on the SOH state of a test battery. In such a case, if excessively many points are selected, there may be a problem with data gaps. Accordingly, the data collection unit 120 selects (some) input data by selecting only a preset number of points. The data collection unit 120 may select input data by selecting a preset number of points in the same way as the discharge process even in the charge process of a test battery.

The sensor unit 130 senses the voltage of a test battery. The sensor unit 130 senses the voltage of a test battery so that the data collection unit 120 can collect data that are generated in proper charge and discharge processes by the discharge unit 111 and the charge unit 115.

The data generation unit 140 generates charge voltage curve data including a charge time and a charge voltage by receiving input data collected by the data collection unit 120 and the charge voltage of a test battery, which is sensed by the sensor unit 130. Furthermore, the data generation unit 140 generates discharge voltage curve data including a discharge time and a discharge voltage by receiving the input data collected by the data collection unit 120 and the discharge voltage of a test battery, which is sensed by the sensor unit 130.

The data generation unit 140 may generate only charge voltage curve data when prediction accuracy of the first AI learning model is a preset value or more. To this end, the processor 11 may evaluate the accuracy of the first AI learning model by applying test data, including charge voltage curve data and discharge voltage curve data that are generated by the data generation unit 140, to the first AI learning model that has been trained by learning data. The processor 11 may enable the data generation unit 140 to generate only charge voltage curve data when the accuracy of the first AI learning model is 95% or more, and may provide, as the input value for the second AI learning model, a result value obtained by predicting discharge voltage curve data based on the charge voltage curve data by using the first AI learning model.

In this case, the counter 170 counts a charge time that is taken to fully charge a test battery and a discharge time that is taken to discharge the test battery, and provides the counted charge time or the counted discharge time to the data generation unit 140.

The pre-processing unit 161 performs pre-processing for learning or prediction on input data collected by the data collection unit 120. The pre-processing unit 161 performs scaling on the input data collected by the data collection unit 120. The pre-processing unit 161 divides input data having various types, which are collected by the data collection unit 120, into data having a maximum value and a minimum value, and performs scaling having a data size on each of the data having the maximum value and the data having the minimum value. Representatively, the pre-processing unit 161 may scale the size of the data within a range of [0, 1]. After the scaling, the pre-processing unit 161 moves each of the scaled data to a zero point and then performs normalization on the data.

Furthermore, the pre-processing unit 161 may image data that have experienced the aforementioned process depending on the type of architecture in which the training unit 165 learns an input value and an output value. The pre-processing unit 161 may image data by using a scheme, such as a Gramian angular field (GAF), a Markov transition field (MTF), or a recurrence plot (RP).

The training unit 165 trains the second AI learning model by using data that have experienced the pre-processing unit 161 as an input value and a battery-available maximum capacity as an output value. Furthermore, the training unit 165 trains the first AI learning model by using charge voltage curve data as an input value and discharge voltage curve data of a battery as an output value.

The training unit 165 trains preset architecture by using data that are collected by the data collection unit 120 depending on the type of data and that are pre-processed by the pre-processing unit 161 as an input value and a battery-available maximum capacity as an output value. In this case, the preset architecture may be an RNN model or long short-term memory (LSTM) model. The training unit 165 trains corresponding architecture.

Furthermore, the training unit 165 may train the second AI learning model by using data that are additionally imaged by the pre-processing unit 161 as an input value and a battery-available maximum capacity as an output value. Architecture that is used in this case may be a model that is specified for image processing, such as a CNN. Architecture that receives an image as an input value relatively shows excellent characteristics in terms of learning efficiency or the accuracy of inference. Accordingly, the training unit 165 may train architecture that is specified for image processing by using the imaged image as an input value.

The training unit 165 may train the first AI learning model by using a hybrid pulse power characterization (HPPC) dataset. In this case, the HPPC dataset includes a curve according to each SOC, various temperatures, various C-rates, and a charge and discharge pulse. A complete dataset includes several hundreds of charge voltage curves and discharge voltage curves that are generated over several samples.

The training unit 165 may use charge voltage curve data and discharge voltage curve data that are generated by the data generation unit 140 as the learning data of the first AI learning model.

The prediction unit 150 tests the SOH of a test battery by inputting an input value that has experienced by the pre-processing unit 161 to a learning model (trained by the training unit 165). As described above, the SOH refers to current performance of the test battery compared to the first performance ratio of the test battery. The first performance of the test battery is information that is provided by a manufacturer, and corresponds to known information. The current performance of the test battery corresponds to the output value of the second AI learning model.

When the charge voltage curve data are input to the first AI learning model (trained by the training unit 165), the first prediction unit 151 may estimate the discharge voltage curve data of the test battery. A charge interval is constant depending on a charge method differently from a discharge interval that varies depending on a load. Accordingly, a more accurate result value can be obtained by predicting the discharge voltage curve data based on the charge voltage curve data, that is, stable data, by using the first AI learning model rather than the result value of the second AI learning model that estimates the SOH based on the discharge voltage curve data and estimating the SOH based on the predicted discharge voltage curve data by using the second AI learning model.

As illustrated in FIG. 3, a voltage change according to the capacity of a battery may be expressed as a charge voltage curve in which a transverse axis is the capacity of the battery and a longitudinal axis is the voltage of the battery. A database includes the charge voltage curve data of each test battery and relation data thereof if different types of test batteries are charged. Battery identification information is stored by being matched with data, respectively. The database may be included as a component different from the memory 12 or may be constructed in some areas of the memory 12.

The charge and discharge speed of a battery that has experienced larger charge and discharge cycles is rapidly changed. The reason for this is that characteristics according to each aging state show a very linear change because charge and discharge have been performed on the battery accurately according to a predetermined rule in a rated manner for battery characteristics.

The data generation unit 140 may easily obtain charge voltage curve data if only a voltage is monitored during battery charge. The first prediction unit 151 may estimate discharge voltage curve data based on the obtained charge voltage curve data.

The second prediction unit 155 infers current performance of a test battery by inputting an input value that has experienced the pre-processing unit 161 to the learning model (trained by the training unit 165). Thereafter, the second prediction unit 155 checks the SOH of the test battery by calculating current performance ratio of the test battery compared to the first performance of the test battery.

The processor 11 predicts the remaining lifespan of the test battery based on the checked SOH and prevents over-charge and over-discharge of the test battery based on the predicted remaining lifespan so that the test battery can be protected.

The memory 12 may store data learnt by the training unit 165 and the first and second AI learning models. The memory 12 stores corresponding data so that the prediction unit 150 can predict the SOH of a test battery by using the AI learning model.

An operation of the discharge unit 111 and a collection process of the data collection unit 120 are illustrated in FIG. 4.

FIG. 4 illustrates various voltage change graphs according to times of test batteries that are discharged by the discharge unit according to an embodiment of the present disclosure.

As illustrated in FIG. 4, the discharge unit 111 discharges the test battery for a preset time at a constant current having a preset size. In this case, the (preset) size of the constant current for the discharge may be determined based on the capacity of the test battery and the preset time for which the discharge will be performed. For example, when discharge is performed on a test battery having a capacity of 100 mA/h per hour for 6 minutes, the discharge unit 111 may control the test battery so that the discharge is performed at a constant current having a size of 10 mA/h. As described above, the discharge unit 111 discharges the test battery at the constant current having the preset size for the preset time.

As illustrated in FIG. 4, a normal test battery is discharged for a predetermined time. In contrast, an abnormal test battery is not discharged during the period in which the normal test battery continues to be discharged, and completes its discharge in the middle.

By considering such a point, the data collection unit 120 may select a set number of points in a situation in which the test battery is discharged, and collects input data at the selected points. After selecting the point, the data collection unit 120 collects the following input data. The data collection unit 120 collects a rate of change (slope, dv/dt) of a voltage according to time at each point, a differential capacity (dQ/dv) at each point, and the size of a voltage within a test battery at timing at which discharge is finally performed.

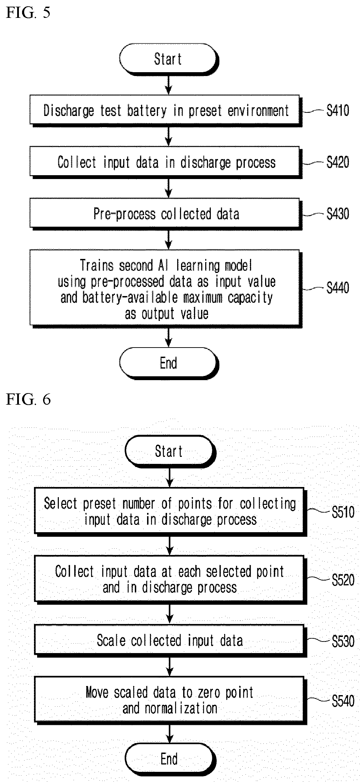

FIG. 5 is a flowchart illustrating a method of training the second AI learning model that enables the apparatus to check the SOH of a test battery according to an embodiment of the present disclosure.

The discharge unit 111 discharges the test battery in a preset environment (S410).

The data collection unit 120 collects input data including a discharge time and a discharge voltage in the discharge process of the test battery (S420).

The pre-processing unit 161 pre-processes the data collected by the data collection unit 120 (S430).

The training unit 165 trains the second AI learning model using the pre-processed data as an input value and a battery-available maximum capacity as an output value (S440).

FIG. 6 is a flowchart illustrating a method of pre-processing, by the apparatus, data according to an embodiment of the present disclosure.

The pre-processing unit 161 selects a preset number of points for collecting input data in a discharge process (S510).

The pre-processing unit 161 collects input data at each selected point and in the discharge process (S520).

The pre-processing unit 161 scales the collected input data (S530).

The pre-processing unit 161 moves the scaled data to a zero point and performs normalization on the scaled data (S540).

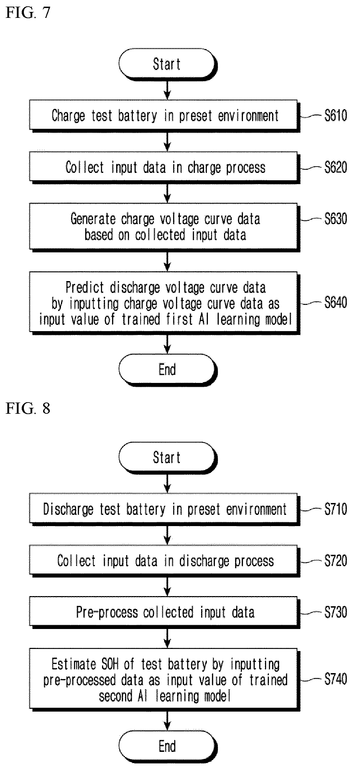

FIG. 7 is a flowchart illustrating a method of predicting, by the apparatus according to an embodiment of the present disclosure, discharge voltage curve data based on the charge voltage curve data of a test battery through the first AI learning model.

The charge unit 115 charges the test battery by providing a charge voltage in a preset environment (S610). The charge unit 115 enables charge voltage curve data to be easily obtained without the need for expensive equipment.

The data collection unit 120 collects input data including a charge time and a charge voltage in the charge process of the test battery (S620). The data generation unit 140 generates charge voltage curve data based on the collected input data.

The pre-processing unit 161 pre-processes the input data collected by the data collection unit 120 (S630).

The training unit 165 may predict discharge voltage curve data by using the second AI learning model using the charge voltage curve data, that is, the pre-processed data, as an input value and the discharge voltage curve data of the test battery as an output value (S640). In this case, the first AI learning model may be trained by using learning data, including a charge voltage curve and a discharge voltage curve, in various environments and various types of batteries like an HPPC dataset.

FIG. 8 is a flowchart illustrating a method of testing, by the apparatus according to an embodiment of the present disclosure, the SOH of a test battery by using the AI learning model.

The discharge unit 111 discharges the test battery in a preset environment (S710).

The data collection unit 120 collects input data in the discharge process of the test battery (S720).

The pre-processing unit 161 pre-processes the input data collected by the data collection unit 120 (S730).

The prediction unit 150 predicts the SOH of the test battery by inputting the pre-processed data as the input value of the trained second AI learning model (S740).

As described above, after the second AI learning model that predicts the SOH of a test battery by using data collected in a discharge process of the test battery, that is, discharge voltage curve data, is constructed, the first AI learning model that predicts discharge voltage curve data based on charge voltage curve data which may be stably obtained may be used in association with the second AI learning model.

Specifically, the data generation unit 140 may generate the charge voltage curve data based on input data collected in a charge process of the test battery. The first prediction unit 151 may provide the discharge voltage curve data based on the charge voltage curve data as a result value by using the first AI learning model that has been pre-trained.

Accordingly, the second prediction unit 155 can predict the SOH of the test battery by providing the second AI learning model that has been pre-trained with the discharge voltage curve data predicted by the first prediction unit 151 as an input value.

The apparatus can calculate test accuracy or rapidness for each battery by comparing a first result value of the SOH of a test battery, which is estimated by using only the second AI learning model, and a second result value of the SOH of the test battery, which is estimated by associating the first AI learning model and the second AI learning model, and may selectively use the first AI or second AI learning model based on the calculated test accuracy or rapidness.

The processes in FIGS. 5 to 8 have been described as being sequentially executed, but this merely illustrates the technical spirit of an embodiment of the present disclosure. In other words, a person having ordinary knowledge in the art to which an embodiment of the present disclosure pertains may variously modify and change the processes by changing and executing the sequence described in each of FIGS. 5 to 8 or executing one or more of the processes in parallel within a range that does not deviate from the intrinsic characteristic of an embodiment of the present disclosure. Accordingly, the processes in FIGS. 5 to 8 are not limited to the time-series sequence.

The processes illustrated in FIGS. 5 to 8 may be implemented in a computer-readable recording medium in the form of a computer-readable code. The computer-readable recording medium includes all types of recording devices in which data readable by a computer system is stored. That is, the computer-readable recording medium includes storage media, such as magnetic storage media (e.g., ROM, a floppy disk, and a hard disk) and optical reading media (e.g., CD-ROM and a DVD). Furthermore, the computer-readable recording medium may be distributed to computer systems connected over a network, and the computer-readable code may be stored and executed in a distributed manner.

The above description is merely a description of the technical spirit of the present embodiment, and those skilled in the art may change and modify the present embodiment in various ways without departing from the essential characteristic of the present embodiment. Accordingly, the embodiments should not be construed as limiting the technical spirit of the present embodiment, but should be construed as describing the technical spirit of the present embodiment. The technical spirit of the present embodiment is not restricted by the embodiments. The range of protection of the present embodiment should be construed based on the following claims, and all of technical spirits within an equivalent range of the present embodiment should be construed as being included in the scope of rights of the present embodiment.

### [Description of reference numerals]

| | | | |
|---|---|---|---|
| 100: | apparatus for testing SOH | | |
| 110: | discharge unit | 115: | charge unit |
| 120: | data collection unit | 130: | sensor unit |
| 140: | data generation unit | 150: | prediction unit |
| 161: | pre-processing unit | 162: | training unit |
| 170: | counter | | |

## Claims

1. An apparatus for checking a state of health (SOH), comprising:
a discharge unit configured to perform discharge on a test battery that is a check target in a preset environment;
a charge unit configured to perform charge on the test battery by providing charge power in a preset environment;
a data collection unit configured to select a set number of points in a process of the test battery being discharged or charged by the discharge unit or the charge unit and to collect input data in the process of the test battery being charged or discharged or at the selected points;
a sensor unit configured to sense a voltage of the test battery;
a data generation unit configured to receive the input data collected by the data collection unit and the voltage of the test battery sensed by the sensor unit and to generate charge voltage curve data or discharge voltage curve data of the test battery;
a first prediction unit configured to predict the discharge voltage curve data of the test battery based on the charge voltage curve data by using a first artificial intelligence (AI) learning model that has been pre-trained; and
a second prediction unit configured to check an SOH of the test battery based on the discharge voltage curve data of the test battery by using a second AI learning model that has been pre-trained.

2. The apparatus of claim 1, further comprising:
a pre-processing unit configured to perform pre-processing on the data collected by the data collection unit; and
a training unit configured to train the second AI learning model by training preset architecture by using data that have experienced the pre-processing unit as an input value and a battery-available maximum capacity as an output value.

3. The apparatus of claim 2, wherein the training unit trains the first AI learning model using the charge voltage curve data of the test battery as an input value and the discharge voltage curve data of the test battery as an output value.

4. The apparatus of claim 1, further comprising a counter configured to count a charge time that is taken to fully charge the test battery and a discharge time that is taken to discharge the test battery and to transmit the counted charge time or discharge time to the data generation unit.

5. The apparatus of claim 1, wherein the set number is approximately 20, within a predefined allowable error margin.

6. The apparatus of claim 1, wherein the data collection unit selects a preset number of points at time intervals.

7. A method of checking a state of health (SOH) of a test battery, the method performed by a computing apparatus comprising at least one processor comprising:
a charge process of charging a test battery by providing charge power in a preset environment;
a discharge process of discharging the test battery in a preset environment;
a collection process of selecting a set number of points in the process of the test battery being charged or discharged and collecting input data in the process of the test battery being charged or discharged or at the selected points;
a data generation process of generating charge voltage curve data or discharge voltage curve data of the test battery based on input data collected in the collection process and a voltage sensed in the process of the test battery being charged or discharged;
a first prediction process of predicting the discharge voltage curve data of the test battery based on the charge voltage curve data by using a first artificial intelligence (AI) learning model that has been pre-trained; and
a second prediction process of checking an SOH of the test battery based on the discharge voltage curve data of the test battery by using a second AI learning model that has been pre-trained.

8. The method of claim 7, further comprising:
a pre-processing process of pre-processing input data collected in the collection process; and
a training process of training the second AI learning model using data pre-processed in the pre-processing process as an input value and a battery-available maximum capacity as an output value.

9. The method of claim 8, wherein the training process comprises training the first AI learning model using the charge voltage curve data of the test battery as an input value and the discharge voltage curve data as an output value.

10. The method of claim 7, wherein the collection process comprises collecting a charge time that is taken to fully charge the test battery and a discharge time that is taken to discharge the test battery.

11. The method of claim 7, wherein the set number is approximately 20, within a predefined allowable error margin.

12. The method of claim 7, wherein the collection process comprises selecting a preset number of points at time intervals.

13. The method of claim 7, wherein the collection process comprises selecting a preset number of points at arbitrary times.
